# EUROPEAN PATENT APPLICATION

(11) **EP 4 239 686 A1**
(43) Date of publication of application: **06.09.2023**
(21) Application number: 23159048.0
(22) Date of filing: 28.02.2023
(51) Int. Cl.: H01L 29/778, H01L 21/338, H01L 21/336, H01L 29/423, H01L 29/417, H01L 29/20

(54) **HEMT DEVICE AND MANUFACTURING PROCESS THEREOF**

(30) Priority: 03.03.2022 IT 202200004037
(71) Applicant: STMicroelectronics S.r.l., 20864 Agrate Brianza (MB) (IT)
(72) Inventor: IUCOLANO, Ferdinando, 95030 Gravina di Catania (CT) (IT); CHINI, Alessandro, 41126 Modena (IT)
(74) Representative: Studio Torta S.p.A.

(57) **Abstract**

The HEMT device (50) is formed by a heterostructure (62), by an insulation layer (68) that extends on the heterostructure and has a thickness along a first direction (Z), and by a gate region (74). The gate region has a first portion (74A) that extends through the insulation layer, throughout the thickness of the insulation layer, and has a second portion (74B) that extends in the heterostructure. The first portion of the gate region has a first width (Lw) along a second direction (X) transverse to the first direction. The second portion of the gate region has a second width (Lb), along the second direction, that is different from the first width.

## Description

The present invention relates to a field-effect High Electron Mobility Transistor (HEMT) device and to the manufacturing process thereof.

HEMT devices are known in which a conductive channel is based on the formation of layers of two-dimensional electron gas (2DEG) with high mobility at a heterojunction, i.e., at the interface between semiconductor materials with different bandgaps. For instance, HEMT devices are known based on the heterojunction between an aluminium and gallium nitride (AlGaN) layer and a gallium nitride (GaN) layer.

HEMT devices based on AlGaN/GaN heterojunctions or heterostructures provide a wide range of advantages that make them particularly suitable for and widely used for different applications. For instance, the high breakdown threshold of HEMT devices is exploited for high-performance power switches; the high electron mobility in the conductive channel allows to obtain high-frequency amplifiers; moreover, the high electron concentration in the 2DEG allows to obtain a low ON-state resistance (R_{ON}).

Furthermore, HEMT devices for radiofrequency (RF) applications typically provide better RF performance than similar silicon LDMOS devices.

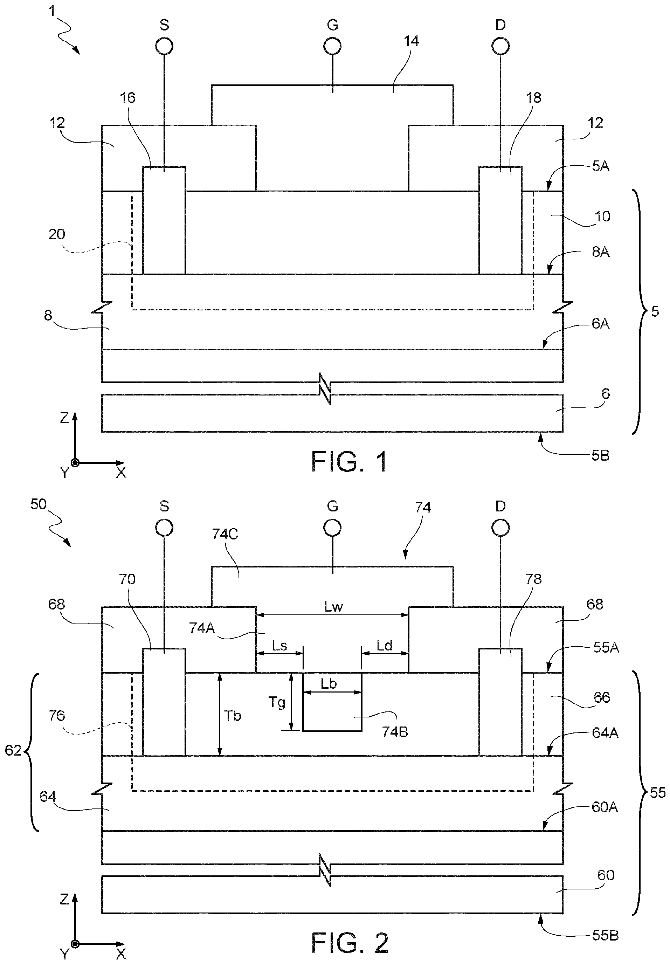

Figure 1 shows a known HEMT device 1 formed in a body 5 having a first and a second surface 5A, 5B.

The body 5 comprises a substrate 6 forming the second surface 5B of the body 5 and having a surface 6A; a channel layer 8, of intrinsic gallium nitride (GaN), extending on the surface 6A of the substrate 6 and having a surface 8A; and a barrier layer 10, of aluminium and gallium nitride (AlGaN), extending on the surface 8A of the channel layer 8 and forming the first surface 5A of the body 5.

The HEMT device 1 further comprises a passivation or insulation layer 12, for example of silicon nitride, extending on the first surface 5A of the body 5; a gate region (or gate electrode) 14, extending through the insulation layer 12, on the first surface 5A of the body 5; and a source region 16 and a drain region 18, which extend in the barrier layer 10 at the sides of the gate region 14.

The body 5 houses an active region 20, indicated by a dashed line in Figure 1, which houses, in use, the conductive channel of the HEMT device 1.

The Applicant has found that the HEMT device 1 has insufficient radiofrequency performance for specific applications, for example the parameters of power density, gain, and drain efficiency of the HEMT device 1 are not sufficiently high.

Moreover, the Applicant has found that the HEMT device 1 also has a low linearity, for example the parameters of gain flatness, amplitude-amplitude modulation, amplitude-phase modulation (AM-PM) and gain expansion are not sufficient for specific applications.

The aim of the present invention is to overcome the disadvantages of the known art.

According to the present invention, a HEMT device and a manufacturing process thereof are thus provided, as defined in the annexed claims.

For a better understanding of the present invention, embodiments thereof are now described, purely by way of nonlimiting example, with reference to the attached drawings, wherein:
- Figure 1 shows a cross-section of a known HEMT device;
- Figure 2 shows a cross-section of the present HEMT device, according to an embodiment;
- Figures 3-8 shows cross-sections of the HEMT device of Figure 2, in successive manufacturing steps;
- Figure 9 shows a cross-section of the present HEMT device, according to a different embodiment; and
- Figure 10 shows a cross-section of the present HEMT device, according to a further embodiment.

Figure 2 shows a HEMT device 50, in particular a normally-on HEMT device, in a Cartesian reference system XYZ comprising a first axis X, a second axis Y and a third axis Z.

The HEMT device 50 is particularly suitable for being used in RF applications such as, for example, 4G and 5G base stations, including evolutions and variants of technology, portable phones, RF cooking devices, drying and heating devices, devices and systems for avionics, radars in the L and S bands, and the like.

The HEMT device 50 is formed in a body 55 having a first surface 55A and a second surface 55B and comprising a substrate 60 and a heterostructure 62 extending on the substrate 60.

The substrate 60, of semiconductor material, for example of silicon or silicon carbide, sapphire (Al₂O₃) or other materials, extends between the second surface 55B of the body 55 and a respective surface 60A.

The heterostructure 62 comprises compound semiconductor materials including elements of the group III-V, extends on the surface 60A of the substrate 60 and forms the first surface 55A of the body 55.

The heterostructure 62 is formed by a channel layer 64 of a first semiconductor material, for example gallium nitride (GaN) or an alloy comprising gallium nitride, such as InGaN, here of intrinsic gallium nitride (GaN), extending on the substrate 60 and having a surface 64A, and by a barrier layer 66 of a second semiconductor material, for example a compound based on a ternary or quaternary alloy of gallium nitride, such as AlₓGa₁₋ₓN, AlInGaN, InₓGa₁₋ₓN, AlₓIn₁₋ₓAl, AlScN, here of intrinsic gallium and aluminium nitride (AlGaN), extending between the surface 64A of the channel layer 64 and the first surface 55A of the body 55.

In detail, the barrier layer 66 has a thickness Tb, in a direction parallel to the third axis Z, comprised, for example, between 15 nm and 40 nm.

The HEMT device 50 further comprises an insulation or passivation layer 68, of dielectric material such as silicon nitride or silicon oxide, extending on the first surface 55A of the body 55; a source region 70 and a drain region 72 extending in direct electrical contact with the heterostructure 62; and a gate region 74 extending between the source region 70 and the drain region 72, in direct electrical contact with the heterostructure 62.

The body 55 houses an active region 76, indicated by a dashed line in Figure 2, which houses, in use, a conductive channel of the HEMT device 50.

The source region 70 and the drain region 72 are of conductive material, for example metallic, and extend deep in the body 55, completely through the barrier layer 66, up to the surface 64A of the channel layer 64.

In practice, the source region 70 and the drain region 72 form, respectively, a source electrode S and a drain electrode D of the HEMT device 50.

In detail, the source region 70 and the drain region 72 form an ohmic contact with the heterostructure 62, in particular with the channel layer 64.

However, the source region 70 and the drain region 72 may extend only partially through the barrier layer 66 and end within the barrier layer 66.

According to a different embodiment, not illustrated here, the source region 70 and the drain region 72 may extend only through the insulating layer 68, up to the first surface 55A of the body 55, i.e. without extending in depth in the barrier layer 66.

According to a further embodiment, not illustrated here, the source region 70 and the drain region 72 may extend also partially through the channel layer 64 and end in the channel layer 64.

Furthermore, the source region 70 and the drain region 72 may extend to depths different from one another in the body 55.

In practice, according to the specific application of the HEMT device 50 and to the specific manufacturing process used for obtaining the source region 70 and the drain region 72, the source region 70 and the drain region 72 may be in direct ohmic contact with the channel layer 64 or may be in electrical contact with the channel layer 64 on account of different physical phenomena, for example through the tunnel effect.

The gate region 74 is of conductive material, for example metallic, and may be formed by a single conductive layer or by a stack of conductive layers, comprising for example gold, nickel, titanium, etc., according to the specific application.

The gate region 74 forms a gate electrode G of the HEMT device 50.

The gate region 74 forms a Schottky contact with the heterostructure 62, in particular here with the barrier layer 66.

The gate region 74 extends partially through the heterostructure 62.

In detail, the gate region 74 comprises a surface portion 74A and a deep portion 74B, contiguous with one another.

The surface portion 74A has a width Lw along the first axis X, for example comprised between 0.4 µm and 1.5 µm, and extends along the third axis Z through the insulation layer 68, up to the first surface 55A of the body 55.

The deep portion 74B extends from the surface portion 74A into the heterostructure 62.

In detail, the deep portion 74B extends partially through the barrier layer 66 and ends within the barrier layer 66, and has a thickness Tg, along the third axis Z, for example greater than 10 nm.

The deep portion 74B has a width Lb along the first axis X different from the width Lw of the surface portion 74A.

In detail, in this embodiment, the width Lb of the deep portion 74B is smaller than the width Lw of the surface portion 74A, for example, the width Lb may be comprised between 50 nm and 1 um.

In this embodiment, the surface portion 74A of the gate region 74 has, on the first surface 55A of the body 55, a width Ld along the first axis X, for example comprised between 0.1 µm and 0.4 um, on a first side of the deep portion 74B towards the drain region 72, and a width Ls along the first axis X, for example comprised between 0.1 µm and 0.4 um, on a second side of the deep portion 74B towards the source region 70.

The width Ld and the width Ls may be equal to one another or different from one another, according to the specific application.

In practice, here, the deep portion 74B extends into the barrier layer 66 from a central part of the surface portion 74A.

However, the deep portion 74B may also extend from a peripheral part of the surface portion 74A, for example towards the source region 70 or towards the drain region 72, i.e. so that one of the width Ld or the width Ls is equal to zero.

Furthermore, in this embodiment, the gate region 74 also comprises a top portion 74C, partially extending on the insulation layer 68.

In detail, the insulation layer 68 extends both on the first side, i.e. towards the drain region 72, and on the second side, i.e. towards the source region 70, of the deep portion 74B of the gate region 74.

The Applicant has found that, in use, the deep portion 74B of the gate region 74 allows an accurate control of the distribution of the electrical field within the heterostructure 62, in particular when the source-drain voltage has high values, for example up to 50 V.

Consequently, the distribution of the electrical field within the heterostructure 62 means that the HEMT device 50 has improved electrical performance with respect to the known HEMT device of Figure 1.

In detail, the Applicant has found that the HEMT device 50 has, for radiofrequency applications, an improved linearity, for example improved values of gain flatness, gain expansion, amplitude-amplitude modulation and amplitude-phase modulation, with respect to the known HEMT device of Figure 1.

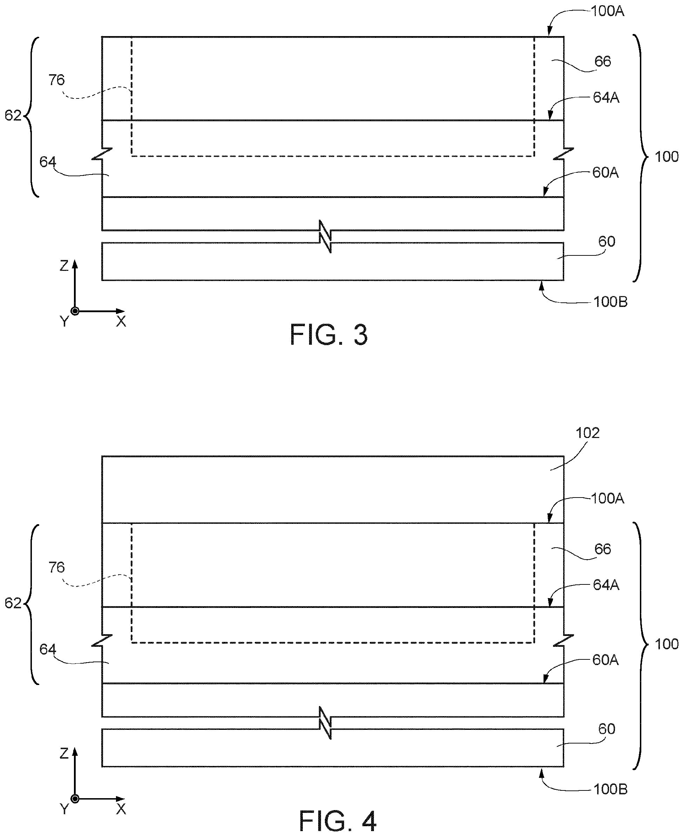

Hereinafter, with reference to Figures 3-8, manufacturing steps of the HEMT device 50 are described, in particular the manufacturing steps that lead to formation of the gate region 74.

Figures 3-8 are limited to the manufacturing of the gate region 74 and do not illustrate steps (simultaneous, preceding and/or subsequent) for the formation of the source region 70 and drain region 72, electrical-contact metallizations, generic electrical connections, and any other element, known per se and not illustrated herein, useful or necessary for operation of the HEMT device 50.

Figure 3 shows a cross-section of a work body 100 having a first surface 100A and a second surface 100B, during a manufacturing step of the HEMT device 50. Elements of the work body 100 that are common to what has already been described with reference to Figure 2, and illustrated in Figure 2, are designated by the same reference numbers and are not further described in detail.

In the work body 100, the substrate 60 and the heterostructure 62, comprising the channel layer 64 and the barrier layer 66, have already been formed.

Next, Figure 4, an insulation layer 102 of dielectric or insulating material, such as silicon nitride, silicon oxide, or some other material, is formed on the first surface 100A of the work body 100.

The insulation layer 102 has a thickness comprised between 5 nm and 300 nm, for example of 70 nm, and is formed by CVD (Chemical Vapour Deposition) or ALD (Atomic Layer Deposition) and, at the end of the manufacturing steps, will form the insulation layer 68 of the HEMT device 50 of Figure 2.

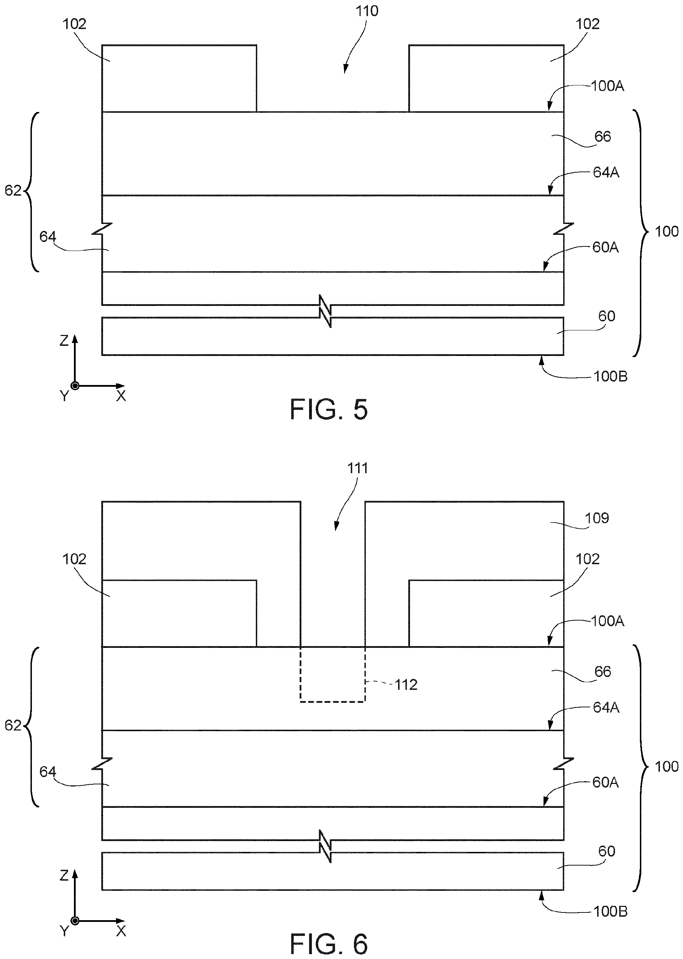

Then, Figure 5, the insulation layer 102 is selectively removed, for example through lithographic and etching steps, so as to form a window 110 that leaves a surface portion of the barrier layer 66 exposed, where it is intended to form the gate region 74.

Next, Figure 6, a mask 109 is formed on the work body 100, for example through known lithographic steps. The mask 109 has an opening 111, which leaves a portion of the first surface 100A of the work body 100 exposed, arranged within the window 110 formed by the insulation layer 102. In practice, the opening 111 exposes the portion of the heterostructure 62 where the deep portion 74B of the gate region 74 of Figure 2 is intended to be formed.

The portion of the first surface 100A of the work body 100 that is exposed by the mask 109 is chemically etched so as to form a recess 112 (indicated by a dashed line in Figure 6) in the barrier layer 66, where the deep portion 74B of the gate region 74 of Figure 2 is intended to be formed.

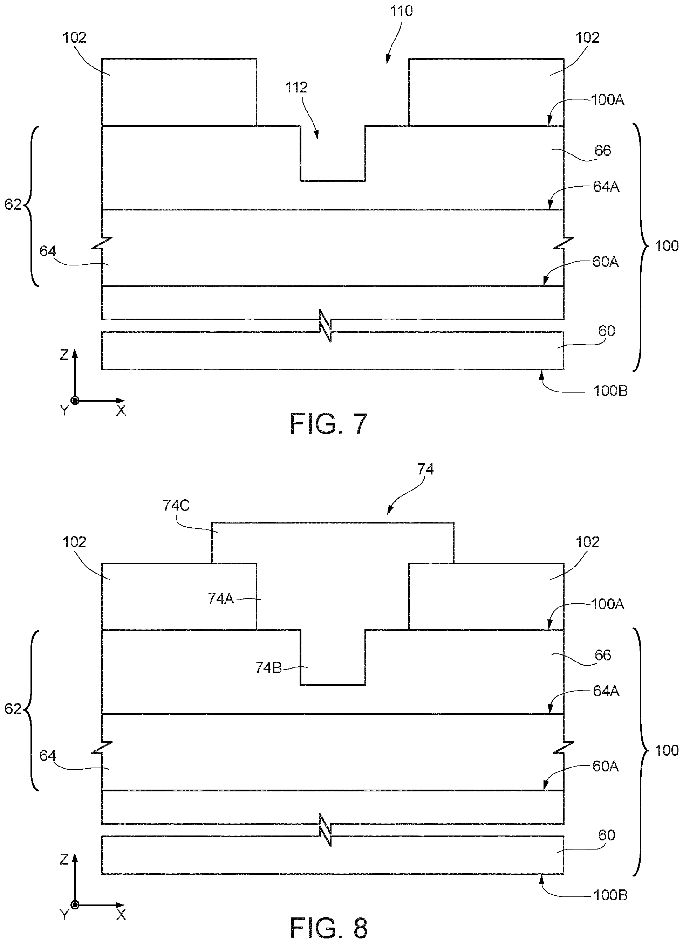

Then, Figure 7, the mask 109 is removed.

The recess 112 has a width, along the first axis X, smaller than the width along the first axis X of the window 110, as described with reference to the second portion 74B of the gate region 74 of Figure 2.

Furthermore, the recess 112 has a thickness, along the third axis Z, smaller than the thickness Tb of the barrier layer 66, for example greater than 10 nm.

Then, Figure 8, the gate region 74 is formed on the work body 100.

In detail, the gate region 74 is formed through deposition of one conductive layer or several conductive layers on top of one another, according to the specific composition of the gate region 74.

Furthermore, formation of the gate region 74 may also comprise one or more lithographic and deposition steps, in order to obtain the desired shape of the gate region 74.

Following upon final manufacturing steps, here not illustrated and known per se, for example dicing of the work body 100 and formation of electrical connections, the HEMT device 50 of Figure 2 is obtained.

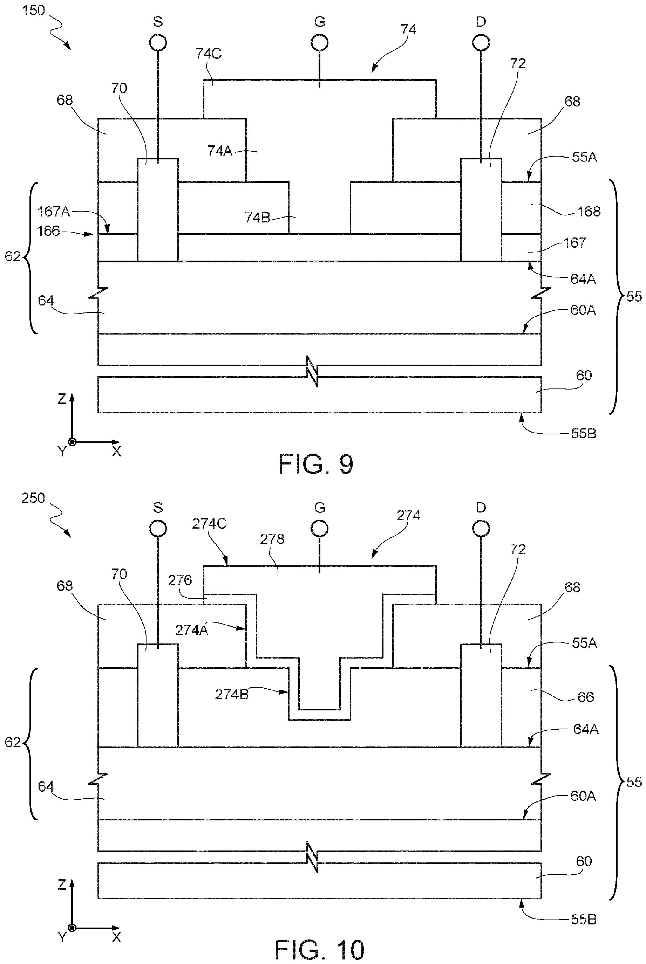

Figure 9 shows a different embodiment of the present HEMT device, here designated by 150. The HEMT device 150 has a general structure similar to that of the HEMT device 50 of Figure 2; consequently, elements in common are designated by the same reference numbers and are not described any further.

The HEMT device 150 is formed in the body 55 comprising the substrate 60 and the heterostructure 62. The HEMT device 50 further comprises the source region 70, the drain region 72 and the gate region 74.

The heterostructure 62 is formed by the channel layer 64 and by a barrier layer, here designated by 166. The barrier layer 166 is formed by a first barrier portion 167 having a surface 167A and extending on the surface 64A of the barrier layer 64, and by a second barrier portion 168 extending on the surface 167A of the first barrier portion 167.

The first barrier portion 167 is of a different material than the second barrier portion 168.

For instance, the first barrier portion 167 and the second barrier portion 168 may both be of AlGaN and each have a respective concentration of aluminium atoms. For instance, the first barrier portion 167 and the second barrier portion 168 may have concentrations of aluminium atoms that are different from one another.

In detail, the first barrier portion 167 may have a concentration of aluminium atoms lower than that of the second barrier portion 168.

For instance, the second barrier portion 168 may have a concentration of aluminium atoms that is not uniform along the axis Z, between the surface 167A of the first barrier portion 167 and the first surface 55A of the body 55.

For instance, the first barrier portion 167 may be of AlN and the second barrier portion 168 may be of AlGaN, in particular with a concentration of aluminium atoms of 250.

The first barrier portion 167 may have a thickness along the third axis Z comprised, for example, between 1 nm and 20 nm. The second barrier portion 168 may have a thickness along the third axis Z comprised, for example, between 10 nm and 30 nm.

The deep portion 74B of the gate region 74 extends through the second barrier portion 168.

In detail, in this embodiment, the deep portion 74B extends throughout the thickness of the second barrier portion 168 up to the surface 167A of the first barrier portion 167.

It will be clear to the person skilled in the art that the HEMT device 150 may be manufactured from a work body in which the heterostructure 62 has already been formed, following manufacturing steps similar to the ones described in Figures 4-8 for the HEMT device 50 and therefore not described any further herein.

In detail, the fact that the first barrier portion 167 and the second barrier portion 168 are of different materials enables a high accuracy to be obtained in the formation of the deep portion 74B of the channel region 74.

In fact, during formation of the recess 112 illustrated in Figures 6 and 7, the first barrier portion 167 may be used as etch stopper, thus guaranteeing a high manufacturing reliability.

Figure 10 shows a different embodiment of the present HEMT device, here designated by 250. The HEMT device 250 has a general structure similar to that of the HEMT device 50 of Figure 2; consequently, elements in common are designated by the same reference numbers and are not described any further.

The HEMT device 250 is formed in the body 55 comprising the substrate 60 and the heterostructure 62. The HEMT device 50 further comprises the source region 70 and the drain region 72.

The HEMT device 250 comprises a gate region, here designated by 274, which is formed also here by a deep portion 274B, which extends in depth into the heterostructure 62, and by a surface portion 274A, which extends on the first surface 55A of the body 55.

Also in this embodiment, the gate region 274 further comprises a top portion 274C, which extends partially on the insulation layer 68.

In this embodiment, the gate region 274 is formed by an insulating portion 276, for example of aluminium oxide, hafnium oxide, silicon nitride, silicon oxide, aluminium nitride, etc., having a thickness comprised, for example, between 1 nm and 10 nm, and by a conductive portion 278, for example formed by one or more layers of conductive material, extending on the insulating portion 276.

In practice, here, the insulating portion 276 extends between the heterostructure 62 and the conductive portion 278; i.e., the insulating portion 276 is in direct electrical contact with the heterostructure 62 and the conductive portion 278 is not in direct electrical contact with the heterostructure 62.

Thanks to the insulating portion 276, the HEMT device 250 may have, in use, a low leakage current that flows from the gate region 274 through the body 55, in particular in radiofrequency applications.

It will be clear to the person skilled in the art that the HEMT device 250 may be manufactured following manufacturing steps similar to the ones described in Figures 3-8 for the HEMT device 50 and therefore not described any further herein.

Finally, it is clear that modifications and variations may be made to the HEMT devices 50, 150, 250 and to the manufacturing process thereof described and illustrated herein, without thereby departing from the scope of the present invention, as defined in the annexed claims.

The source region 70, the drain region 72, and the gate region 74 may extend along the second axis Y according to different shapes and configurations, according to the specific application, in a per se known manner and therefore not discussed in detail. For instance, in top view, not illustrated herein, the source region 70, the drain region 72, and the gate region 74 may have the shape of elongated strips along the second axis Y, or may have a circular shape or any other shape, regular or irregular.

For instance, the source region 70, the drain region 72, and the gate region 74 may each form a portion of a respective region having a more complex shape and electrically connected to other portions through specific metal connections.

For instance, the channel layer 64 and the barrier layer 66 may be each formed by a plurality of layers mutually overlapped , for example one or more layers of GaN, or GaN-based alloys, specifically doped or of an intrinsic type, according to the specific application.

For instance, the HEMT device 50 may comprise a stack of mutually overlapped layers extending between the substrate 60 and the heterostructure 62, for example including a buffer layer and a hole-supply layer, in a per se known manner.

For instance, the present HEMT device may be of a normally-off type.

The different embodiments described above may be combined in order to provide further solutions.

## Claims

1. A HEMT device (50; 150; 250) comprising:
a heterostructure (62);
an insulation layer (68) extending on the heterostructure and having a thickness along a first direction (Z) ; and
a gate region (74; 274) comprising a first portion (74A; 274A) extending through the insulation layer, throughout the thickness of the insulation layer, and having a first width (Lw) along a second direction (X) transverse to the first direction (Z), and a second portion (74B; 274B) extending in the heterostructure and having a second width (Lb) along the second direction, the second width being different from the first width.

2. The HEMT device according to the preceding claim, wherein the heterostructure comprises a channel layer (64) and a barrier layer (66; 166) extending on the channel layer, the insulation layer extending on the barrier layer, the second portion (74B) of the gate region (74) extending in the barrier layer.

3. The HEMT device according to the preceding claim, wherein the second portion (74B; 274B) of the gate region (74; 274) extends partially through the barrier layer (66; 166) and ends in the barrier layer.

4. The HEMT device according to any one of the preceding claims, wherein the width (Lw) of the first portion (74A; 274A) of the gate region (74; 274) is greater than the width (Lb) of the second portion (74B; 274B) of the gate region (74; 274) .

5. The HEMT device according to any one of claims 2-4, wherein the barrier layer (166) comprises a first barrier portion (167) of a first material and a second barrier portion (168) of a second material different from the first material, the first barrier portion extending between the channel layer (64) and the second barrier portion.

6. The HEMT device according to the preceding claim, comprising an interface (167A) between the first barrier portion (167) and the second barrier portion (168), wherein the second portion (274B) of the gate region (274) extends in the second barrier portion (168) up to the interface between the first barrier portion and the second barrier portion.

7. The HEMT device according to claim 5 or 6, wherein the first barrier portion (167) and the second barrier portion (168) have concentrations of aluminium atoms that are different from one another.

8. The HEMT device according to the preceding claim, wherein the first barrier portion (167) has a concentration of aluminium atoms smaller with respect to the second barrier portion (168).

9. The HEMT device according to any of claims 5-7, wherein the first barrier portion (167) is of AlN and the second barrier portion (168) is of AlGaN.

10. The HEMT device according to any one of the preceding claims, wherein the gate region (74) comprises conductive material in direct electrical contact with the heterostructure (62).

11. The HEMT device according to any one of claims 1-9, wherein the gate region (274) comprises an insulating layer (276) and a conductive layer (278), the insulating layer extending between the heterostructure and the conductive layer.

12. The device according to any one of the preceding claims, further comprising:
a source region (70) of conductive material extending in direct electrical contact with the heterostructure (62); and
a drain region (72) of conductive material extending in direct electrical contact with the heterostructure, at a distance from the source region along the second direction (X),
wherein the gate region (74; 274) extends, in the second direction, between the source region and the drain region.

13. A process for manufacturing a HEMT device (50; 150; 250) comprising:
forming, on a heterostructure (62), an insulation layer (68, 102) having a thickness along a first direction (Z); and
forming a gate region (74; 274), wherein the gate region comprises a first portion (74A; 274A) extending through the insulation layer, throughout the thickness of the insulation layer, and having a first width (Lw) along a second direction (X) transverse to the first direction (Z), and a second portion (74B; 274B) extending in the heterostructure and having a second width (Lb) along the second direction, the second width being different from the first width.

14. The manufacturing process according to the preceding claim, wherein forming a gate region comprises:
forming a window (110) in the insulation layer;
forming a recess (112) in the heterostructure (62), at the window; and
depositing at least one conductive layer in the window.

15. The manufacturing process according to claim 13 or 14, wherein the heterostructure comprises a channel layer (64) and a barrier layer (66; 166) extending on the channel layer, the insulation layer extending on the barrier layer, the second portion (74B) of the gate region (74) extending in the barrier layer,
wherein the barrier layer (166) comprises a first barrier portion (167) of a first material and a second barrier portion (168) of a second material different from the first material, the first barrier portion extending between the channel layer (64) and the second barrier portion,
wherein forming a gate region comprises forming a recess in the second barrier layer (168) by using the first barrier portion (167) as etch-stopper.
